# EUROPEAN PATENT APPLICATION

(11) **EP 4 472 364 A1**
(43) Date of publication of application: **04.12.2024**
(21) Application number: 23177083.5
(22) Date of filing: 02.06.2023
(51) Int. Cl.: H05K 3/28, H05K 1/02, H05K 3/10, H05K 3/12

(54) **INKJET PRINTER FOR BOARD-LEVEL EMI SHIELDING**

(71) Applicant: Heraeus Electronics GmbH & Co. KG, 63450 Hanau (DE)
(72) Inventor: LU, Xintao, Shanghai, 201108 (CN); XIN, Binbin, Shanghai, 201108 (CN); AN, Shouming, Shanghai, 201108 (CN); WANG, Dan, Shanghai, 201108 (CN); STADNIK, Alan Paul, 63450 Hanau (DE)
(74) Representative: Heraeus IP

(57) **Abstract**

The invention relates to a process for preparing a conductive structure, in particular an electromagnetic interference shielding, on an electrically insulating surface of a first electronic substrate comprising the steps, providing a first electronic substrate comprising a first electrically insulating surface, printing a molecular metal precursor ink on at least a part of the first electrically insulating surface to obtain a printed structure, treating the printed structure with infrared (IR) radiation to obtain a sintered structure, treating the sintered structure with ultraviolet (UV) radiation to obtain a conductive structure. Furthermore the invention relates to a device for carrying out the process of the invention.

## Description

### TECHNICAL FIELD

The invention relates to the field of printed electronics. More specifically it relates to a method for preparing conductive structures, like for example an electromagnetic interference shield on a printed circuit board assembly or a flexible PCB. In addition, the invention relates to a device for carrying out the process of the invention.

### BACKGROUND

The semiconductor industry, in particular for consumer electronics devices, searches for ongoing improvement of the integration density in order to produce smaller electronic components, and smaller electronic devices comprising these electronic components. This includes amongst others printed circuit board assemblies (PCBA) and flexible printed circuit boards (Flex-PCB). This search not only focuses on miniaturization of the electronic components, but also to develop methods to manufacture electromagnetic interference shielding which has also a smaller demand of space, and in consequence, improved techniques to manufacture electromagnetic interference shields directly on the electronic component. More specifically this requires advances in functional film manufacturing.

Several procedures are known to equip electronic circuitry with electromagnetic interference shields. Such methods include especially applying conductive foils, conductive fabric, conductive non-woven or conductive pressure-sensitive-adhesive (PSA) tapes on the structures to be shielded. Other methods include coatings made by printing conductive pastes, by vacuum deposition of elemental metal layers, by electrochemical methods, and combinations thereof. Most of these procedures either imply at least one step where a substantial impact of heat, a wet process, vacuum and/or a time-consuming treatment is required to produce a dense and conformal and coherent layer of a shielding material on an electronic substrate. Most of these techniques further require a preceding masking and subsequent de-masking step to selective produce or transfer an electromagnetic interference shield accurately to dedicated areas of the electronic substrate while keeping other areas free from those shields.

It is an object of the present invention to provide an improved process for preparing a conductive structure, in particular an electromagnetic interference (EMI) shield which is easy and reliable.

It is another object of the present invention to provide a method by which conductive structures with a smaller space requirement can be produced.

It is another object of the present invention to provide a method by which conductive structures can be applied on tilted or vertical surfaces of 3D-objects.

Preferably the process of the invention produces conductive structures exhibiting strong adhesion to an underlying substrate and have high electrical conductivity.

In addition, it is also an object of the invention to provide a device for carrying out the process of the invention, in particular it is an object of the invention to provide a device for preparing conductive structures on 3D objects.

At least one of the objectives is solved by the subject matter of the independent claims. The dependent claims describe preferred embodiments of the invention.

### SUMMARY

At least one of the objectives is solved by the subject matter of the independent claims. The dependent claims describe preferred embodiments of the invention.

In a first aspect the invention relates to a process for preparing a conductive structure, in particular an electromagnetic interference shielding, on an electrically insulating surface of a first electronic substrate comprising the steps,
a) providing a first electronic substrate comprising a first electrically insulating surface,
b) printing a molecular metal precursor ink on at least a part of the first electrically insulating surface to obtain a printed structure,
c) treating the printed structure with infrared (IR) radiation to obtain a sintered structure,
d) treating the sintered structure with ultraviolet (UV) radiation to obtain a conductive structure and
e) optionally, after step e) heating the electronic substrate to a temperature of 50°C - 200°C.

In a second aspect the invention relates to a device for manufacturing a conductive structure, in particular an electromagnetic interference shielding, on an electronic substrate, comprising
a) an input stage configured to provide at least one first electronic substrate comprising an electrically insulating surface,
b) an ink printing unit configured to print a molecular metal precursor ink on the electrically insulating surface of one or more electronic substrates to form at least a printed structure,
c) at least one IR radiating unit configured to apply IR radiation to the printed structure to obtain a sintered structure, and
d) at least a UV radiating unit configured to apply UV radiation to the printed structure or the sintered structure to obtain a conductive structure and
e) optionally an oven arranged to heat the electronic substrate leaving the UV radiating unit.

### BRIEF DESCRIPTION OF THE DRAWINGS

The following schematic drawings show aspects of the invention for improving the understanding of the invention in connection with some exemplary illustrations, wherein
- Figure 1: shows a process chart of the method according to the invention.
- Figure 2: shows an alternative process chart of the method according to the invention.
- Figures 3 to 5: show schematic drawings of various embodiments of the device according to the invention.
- Figure 6: shows a schematic drawing of a printing unit combined with an IR radiating unit.

### DETAILED DESCRIPTION

It is an object of the present invention to provide an improved process for preparing a conductive structure, in particular an electromagnetic interference (EMI) shielding which is easy, reliable. Preferably the process of the invention produces conductive structures exhibiting strong adhesion to an underlying substrate and have high electrical conductivity.

In addition, it is also an object of the invention to provide a device for carrying out the process of the invention.

At least one of the objectives is solved by the subject matter of the independent claims. The dependent claims describe preferred embodiments of the invention.

In a first aspect the invention relates to a process for preparing a conductive structure, in particular an electromagnetic interference shielding, on an electrically insulating surface of a first electronic substrate comprising the steps,
a) providing a first electronic substrate comprising a first electrically insulating surface,
b) printing a molecular metal precursor ink on at least a part of the first electrically insulating surface to obtain a printed structure,
c) treating the printed molecular metal precursor ink with IR radiation to obtain a sintered structure,
d) treating the sintered structure with UV radiation to obtain a conductive structure and
e) optionally, after step e) heating the electronic substrate to a temperature of 50°C - 200°C.

Preferably the steps are carried out in the specified order. However, the skilled person might change the order of some or all of the steps wherever he considers this to be suitable. In some cases, additional steps can be introduced before, in between or after the displayed steps.

Optionally, a cleaning step may be introduced between step a) and step b). Preferably the cleaning comprises plasma cleaning of the electronic substrate. The plasma may be for example air, oxygen, nitrogen or argon. The cleaning step can remove particles or adsorbed contamination from the electrically insulating surface.

The conductive structure herein preferably is an electrically conductive structure. Optionally the conductive structure also exhibits good thermal conductivity. The conductive structure may comprise metal or conductive polymer. In a preferred embodiment the conductive structure comprises metal or consists of metal. In the context of the invention the term "metal" comprises elemental metals and metallic alloys, i.e. metallic mixtures. Preferably the metal is selected from the group consisting of silver, gold, copper, platinum, palladium, ferrite and nickel.

Metallic alloys comprise a mixture of at least two components wherein the first component is a metal and the at least one further component is an alloying component. Metallic alloys exhibit metallic behavior, i.e., metallic bonding, high electrically conductivity, metallic gloss. The first component may preferably be selected from the group consisting of silver, gold, copper, platinum, palladium and nickel. The alloying component may comprise a metal, e.g. a metal selected from the group specified for the first component, a semi-metal, e.g. silicon, or a nonmetal, e.g. carbon, boron.

In an example the conductive structure may be a conductor track, a printed line, a printed lane a printed wire or a conductive layer. Optionally the conductive layer is continuous and more preferably defect-free. Alternatively, the conductive layer may contain two or more separate parts.

In a preferred embodiment of the invention the conductive structure functions as an EMI-shielding layer. An electromagnetic interference shielding layer may shield sensitive electronic components, including semiconductor chips, from electromagnetic radiation from the environment. The shielding in particular includes shielding electronic components from each other, from noise of electronic components or to prevent chips from influencing each other. The EMI shielding layer may also shield passive components, like e.g. electrical conductors, from electromagnetic interference. The frequencies to be shielded by an EMI-shielding layer may span a broad range of radio frequencies, for example in the range from 100 kHz to 30 GHz. In case the conductive structure functions as an EMI-shielding layer it may optionally be connected to a ground.

The conductive structure is prepared on an electrically insulating surface of a first electronic substrate. In the context of the invention an electronic substrate may be understood as a substrate used to prepare an electronic device. Preferably the electronic substrate comprises at least one electronic component like, e.g. a semiconductor chip, a transistor, a resistor, a capacitor, a connector or the like.

More preferably the electronic substrate may comprise a circuit board or a system-in-package (SIP). The circuit board may be selected from the group containing a breadboard, a stripboard, or a printed circuit board (PCB). The PCB may be selected from the group containing singlesided printed circuit boards, double-sided printed circuit boards, multi-layer PCB, rigid printed circuit board, flexible printed circuit board (flexPCB) or rigid-flex PCB. The circuit board in some embodiments may contain electronic components or alternatively the circuit board may not contain an electronic component.

The electrically insulating surface of a first electronic substrate may comprise a dielectric material, preferably selected from the group consisting of low molecular organics, polymers, glass, and ceramics. In one embodiment the insulating surface is formed from a dielectric layer, preferably a polymer layer. The polymer layer may be formed on a circuit board, preferably a PCB. In one embodiment the dielectric layer is arranged on some or all of the electrically conductive components of the electronic substrate, especially to prevent any short circuits. In some embodiments the first insulating surface may also comprise electrically insulating regions of a circuit board.

In some embodiments the first insulating surface of the electronic substrate has a three-dimensional surface morphology, which means it is not even and flat. The three-dimensional surface morphology may result from one or more electronic components present on the electronic substrate wherein the electronic components are at least partly covered with a thin dielectric layer. This means the electronic components are not fully molded in the dielectric layer. Alternatively, the first insulating surface of the electronic substrate may be even and flat. In some embodiments, specific dielectric layers can also be reversibly attached to the electronic substrate. This means that under specific condition, such as high temperature, the dielectric layer may optimally be removed from the electronic substrate.

In step a) a first electronic substrate comprising a first electrically insulating surface is provided. Optionally the first insulating surface is manufactured before step a), for example by forming a dielectric layer on the electronic substrate. In particular the dielectric layer may be formed by printing, like for example ink jet printing, spray coating or dispensing.

In step b) a molecular metal precursor ink is printed on at least a part of the first electrically insulating surface to obtain a printed structure. The molecular metal precursor may be applied on a region of the electronic substrate above at least one electronic component or alternatively the molecular metal precursor ink may be printed such that no electronic component is arranged in the printed region.

A molecular metal precursor ink comprises at least a molecular metal precursor and a vehicle. The molecular metal precursor may comprise a metal organic decomposition (MOD) compound or a metal complex. A MOD compound preferably comprises metal salt, in particular selected from the group containing metal- carboxylates, - nitrates, - nitrites, - oxides, - carbonates, - azides, - halogenocarboxylates, - hydroxycarboxylates and - sulfonates.

The metal complex may be selected for example from the group consisting of acetylacetonate, amines, N-heterocycles, amino alcohols, acid amides and nitriles.

The vehicle of the ink may be an organic or an aqueous vehicle. The vehicle may comprise one or more components selected from the group of solvents, rheology modifiers, adhesion promoters and stabilizers. Preferably the vehicle at least includes a solvent. Preferably the molecular metal precursor is at least partly or completely soluble in the solvent. Optionally the molecular metal precursor ink does not contain intentionally added particles. More preferably the molecular metal precursor ink does not comprise more than 1 wt.% particles and more preferably not more than 0,1 wt.% particles, wherein the particles are preferably metal particles. It is further preferred that the molecular metal precursor is stable in the vehicle for at least seven days or more, in particular 14 days or more.

Solvents of the vehicle may preferably be selected from the group consisting of water and organic solvents. Organic solvents may comprise at least one compound selected from the group consisting of xylene, propylenglycolbutylether, dipropylenglycolpropylether, diethylenglycoldimethylether, butylglycolate, hexylenglycole, nonanole, decanol, isopentylalcohol, cyclohexanol, terpineol, linalool, 1,8-cineol, dimethylsulfoxide and glycerole.

Rheology modifiers may be selected for example from the group of cellulose, modified cellulose and urea-derivates, e.g., BYK 410. Adhesion promoters may be selected for example from ultraviolet-curable adhesives and hot-melt adhesives.

Catalysts may for example be selected from the group containing aminomethylpropanol, ethylendiamine, cyclohexylamine and ethylenglycol.

In a particularly preferred embodiment, the molecular metal precursor ink comprises a metal carboxylate, e.g. silver carboxylate, and an organic solvent, e.g. selected from aromatic and/ or aliphatic hydrocarbons.

In some embodiments the ink may contain metal particles. The metal particles may have an average particle diameter d₅₀ in the range from 1 nm to 10 µm. Preferably the ink does not contain metal particles in an amount of more than 1 wt.-%, preferably not more than 0,5 wt.%. In some non-inventive examples, the ink may only comprise metal particles, in particular nanoparticles, e.g. with an average diameter in the range from 1 - 100 nm.

The ink has a viscosity suitable for the selected printing technology and can be selected be a person skilled in the art of printing.

The molecular metal precursor ink is printed partly or fully on the first electrically insulating surface. The printing method optionally may be selected from the group comprising inkjet printing, screen printing, off-set printing, spray coating, and dispensing.

The design of the obtained printed structure is typically not limited and can have any layout the skilled person in the field of electronics considers to be useful.

The thickness of the printed structure may vary depending on which printing method is used. Typically, the thickness of the printed structure is in in the range from 50 nm to 1,5 µm. Inkjet printing is preferred because it generally does not require masking and allows forming fine features on the surface.

In step c) the printed structure is treated with infrared (IR) radiation to obtain a sintered structure. Preferably the intensity of the infrared radiation is adjusted to heat the printed structure. More specifically the printed structure may be heated such that the solvent at least partly evaporates. Evaporation preferably takes place without decomposition of the solvent. After infrared radiation treatment sintered structure is obtained. In some cases, the thickness of the sintered structure is lower than the thickness of the printed structure, e.g. due to removal of vehicle and subsequent shrinkage. In the context of the present invention a sintered structure shall be understood to be a printed structure from which at least part of the vehicle contained in the ink is removed. Thus, the sintered structure may preferably be understood to be a dried printed structure, and it may alternatively also be termed a "pre-sintered" structure to indicated that conversion to a conductive structure is not finally completed. It is not strictly necessary that the sintered structure comprises sintered particles in the narrow sense. On the other hand, sintering of particles by surface diffusion of atoms below the melting temperature of the respective metal may not be excluded. In a preferred embodiment the sintered structure is fixed on the electrically insulating surface and does not flow under standard conditions. This is particularly advantageous if the molecular metal precursor ink of the invention is printed on a three-dimensional surface structure, like e.g. a PCBA, a Flex-PCB or a SIP, because it sticks to tilted surfaces and side walls and withstands gravity.

The infrared radiation intensity preferably is in the range from 0.5 W/cm² to 10 W/cm², preferably in the range from 1.0 W/cm² to 8 W/cm². Infrared radiation in the context of the present invention may have a wavelength in the range from 700 nm to 5 µm, preferably in the range from 1.5 µm to 4.5 µm. Irradiation time may for example be in the range from 10 s - 1000 s.

Preferably step c) is carried out in parallel with printing step b). In other words, printing of the printed structure continues while parts of the printed structure which are already present on the first insulating surface are treated with infrared irradiation. In some cases, this means the freshly printed structure is irradiated to dry directly after it has been formed on the first insulating surface. Advantageously this ensures higher structural integrity of the printed and subsequently sintered structure.

In step c) preferably a sintered structure is obtained which comprises not more than 10 wt.-%, preferably not more than 5 wt.% of vehicle components, based on the total weight of the sintered structure.

In step d) the sintered structure from step c) is treated with UV radiation to obtain a conductive structure. UV radiation in the context of the present invention may be understood to include electromagnetic radiation having a wavelength in the range from 100 - 400 nm. Treatment with UV radiation is preferably carried out such that the molecular metal precursor is at least partly or fully converted into metal such that the sintered structure becomes electrically conductive.

UV radiation intensity preferably is in the range from 1.0 W/cm² to 12.0 W/cm², preferably in the range from 2.0 W/cm² to 9.0 W/cm². UV radiation in the context of the present invention may have wavelength in the range from 100 nm to 450 nm, preferably in the range from 365 nm to 420 nm. Irradiation time may vary depending on the ink used and may for example be in the range from 10 s - 1000 s. In case several layers of molecular metal precursor ink are printed the UV-radiation intensity for subsequent layers may be the same or different from each other.

Optionally, after step e) the electronic substrate is heated to a substrate temperature of 50°C - 200°C, preferably 100°C to 200°C and for a duration of 20 - 500 mins. The optional heating can e.g. improve conductivity of the conductive structure and/or adhesion to the first insulating surface.

In some embodiment this step e) is carried out after the last infrared and/or UV irradiation step. Alternatively, in particular in cases wherein several layers of molecular metal precursor ink are printed and irradiated, heating the whole electronic substrate to a temperature of 50°C - 200°C can be carried out at any stage of the process as an additional step. In some cases, this may improve the overall efficiency and electrical conductivity of the structure. Preferably heating is carried out in an oven. A final heating step in an oven is advantageous because oven temperature can be controlled more precisely compared to the heating effected by UV-curing, especially, when the substrate is sensitive to high temperatures, and therefore the heating load of the entire electronic substrate can be reduced.

In some embodiments the conductive structure may be formed from two or more layers of molecular metal precursor ink. In a preferred embodiment steps b) to d) are repeated once or multiple times on the first electrically insulating surface., or on the previously prepared conductive structure or on both. The intensity of the irradiation in steps consecutive IR and UV treatments can be adjusted individually, e.g. to control the temperature and / or to improve the conversion of the ink into a conductive structure. The conductive structure prepared by repetition of steps b) to d) may be termed additional conductive structure.

In a preferred example the layout of an additional conductive structure at least partly overlaps with the layout of the first conductive structure. Yet more preferred the layout of some, or all conductive structures are the same. In this case the overall thickness of the conductive structure may be increased. Typically, an additional conductive structure added to the first conductive structure has a thickness in the range from 100 nm to 10 µm.

The conditions for infrared radiation in the first step c) and optional subsequent repeated steps c) may be the same or differ from each other.

The conditions for UV radiation in the first step d) and optional subsequent steps d) may be the same or differ from each other. For example, UV irradiation in one or more repeated steps d) may be longer and or the intensity of irradiation may be higher.

The process according to the invention may preferably be carried out on several electronic substrates at the same time. Since step d) typically takes longer than steps b) and c), steps a) to c) or even steps a) to d) may be carried out with a second electronic substrate while the UV radiating step is carried out on the first electronic substrate. In this way the output of the process may be increased.

In yet another preferred embodiment the process steps b) to d) are carried out at least once on a second electrically insulating surface of the first electronic substrate. Preferably the optional step e) is carried out after the last UV irradiation step carried out on the first electronic substrate. This means that the electronic substrate is exposed to elevated temperatures only once. This may be of relevance if the electronic substrate comprises temperature sensitive electronic components or joints. For example, solder connections may be sensitive to elevated temperature, if partial remelting of the solder alloy occurs. Typically, the processes in electronic industry are designed such that thermal stress during production is kept as low as possible.

As already indicated above the process of the invention can be used on a variety of substrates, for example on a flexible PCBs (also termed flexPCB or FPCB) or SIPs. EMI shields of FPCBs prepared according to the process of the invention may have certain advantages such as an improved bending capability. This can be particularly useful in FPCBs for foldable smartphones. For FPCBs it is often required to cover the sidewalls with an EMI shielding layer. Inkjet printing can provide a much more efficient way to cover the sidewalls than the current solution of EMI shielding hot-melt adhesive films or tapes of the prior art. Furthermore, an EMI shielding prepared according to the process of the invention can have better EMI shielding performance than state of the art EMI shields comprising conductive fabric pressure sensitive adhesive (PSA) tape, heat-melt adhesive EMI shielding tape and conductive metal PSA tape. An additional advantage of the present invention is that it is easy to tune the electrical conductivity of an EMI shielding layer, compared to layers of pressure sensitive adhesive tape or hot-melt adhesive films, because this would require modifications of the manufacturing process. In contrast inkjet printing can change the conductivity of EMI shielding layers by adjusting the thickness. Modifications can also be introduced in-line during production.

Another advantage of inkjet printing is that conductive structures may be applied specifically at the required locations which reduces waste and while consuming less energy. A heat-melt adhesive EMI shielding tape comprises at least four layers (reinforcement layer, insulation layer, shielding layer and adhesive layer), which in turn introduces a mismatch of thermal expansion coefficients. This may negatively impact the bending performance. A conductive structure of one layer of printed conductive ink having a thickness of 100 nm - 500 nm can provide equal or higher EMI shielding performance compared to adhesive tape of 10 µm - 15 µm thickness.

After the heat treatment in step e) optionally a protective layer may be applied to the conductive layer. This protective layer may for example protect the conductive structure from mechanical damage. Typically, the layer thickness of the conductive structure including a protective layer is 10 µm or less. Preferably such structures will have beneficial bending performance. Test result indicate that neither appearance nor sheet resistance change significantly after 25,000 bending cycles.

In a second aspect the invention relates to a device for manufacturing a conductive structure, in particular an electromagnetic interference shielding, on an electronic substrate, comprising
a) an input stage configured to provide at least one first electronic substrate comprising an electrically insulating surface,
b) an ink printing unit configured to print a molecular metal precursor ink on the electrically insulating surface of one or more electronic substrates to form at least a printed structure,
c) at least one IR radiating unit configured to apply IR radiation to the printed structure to obtain a sintered structure,
d) at least a UV radiating unit configured to apply UV-radiation to the printed structure or the sintered structure to obtain a conductive structure.
e) optionally an oven arranged to heat the electronic substrate leaving the UV radiating unit.

Preferably all units and parts of the device are integrated into one machine.

The use of an oven may provide easy and stable control of the temperature treatment of the conductive structures and the entire electronic substrate. An oven is also advantageously used in mass-production and may be operated at low cost. In some embodiments the oven may not be thermally separated from the remaining units of the device to prevent excessive heat of temperature sensitive components, like e.g. an inkjet print head.

Optionally, the device comprises an output stage configured to collect the electronic components after the final treatment step, e.g. to prepare the products for further use or packaging.

In some non-inventive cases, the IR-unit may be optional if the requirement for a compact machine does not allow an IR irradiating unit.

Preferably the device is configured to carry out the process of the invention as detailed herein.

The device for manufacturing a conductive structure preferably contains a printing device, e.g, an ink jet printer, a spray coating machine, a screen printer, or other in-line film coating equipment.

The device is suitable for producing a conductive structure, preferably an EMI shield, in particular on a printed circuit board assembly (PCBA), as detailed herein for the process.

Optionally one or more of the units are connected by transporting means. This may be for example a conveyor belt. The transporting means may be embedded into the production line.

The device comprises an input stage configured to provide at least one first electronic substrate comprising an electrically insulating surface. The input stage may be a manual input stage or an automated input stage. Typically, the input stage comprises a holder for one or more substrates which allows to handle those substrates with high positional accuracy within the process. Preferably the holder is temperature resistant in the range from room temperature to140°C, e.g. if the substrate or an ink requires high temperature environment during printing.

The device comprises an ink printing unit configured to print a molecular metal precursor ink on the electrically insulating surface of one or more electronic substrates to form at least a printed structure. The ink printing unit comprises at least one ejection device for the ink. This ejection unit preferably contains a print head in particular an ink jet print head. Suitable print heads for printing conductive inks are known to the skilled person and can be selected according to the conducted process.

The ink printing unit is configured to apply molecular metal precursor ink on a three-dimensional structure. This may include configurations wherein the substrate or the printing unit are tilted relative to each other, rotated relative to each other, the distance between ink printing unit and substrate are varied or combinations thereof. In a preferred embodiment the printing unit is configured to move over the surface of the electronic substrate. Alternatively, the substrate may move relative to a fixed printing unit.

Further the device contains an IR radiating unit configured to apply IR radiation to the printed structure to obtain a sintered structure. The IR radiating unit may for example contain an IR source, e.g. an IR lamp. The IR radiating unit may either be configured to apply IR radiation specifically to a printed structure, e.g. by a light beam, or the IR radiating unit is configured such that it can provide an even irradiation profile all over the electronic substrate comprising the electrically insulating surface. The power of the IR radiating unit is sufficient to heat the printed structure to a temperature in the range from 50°C to 250°C.

In a preferred embodiment the IR radiating unit is arranged to irradiate the printed structure while the ink printing unit operates. Preferably the IR radiating unit and the ink printing unit are arranged to move together. This may be achieved by coupling the ink printing unit and the IR radiating unit to each other. In this way the printed structure of the molecular metal precursor ink which has been deposited on the electrically insulating surface of the electronic substrate may be irradiated directly after deposition. The radiation leads to heating which effects the evaporation of at least some of the solvent and/or vehicle of the molecular metal precursor ink. In this way the printed structure is dried. Thus, the geometry of the printed structure can be fixed, and the molecular metal precursor ink cannot flow any longer.

If the printing and the IR radiating units are coupled together to move in parallel, preferably a thermal insulation is arranged between the two units. In some cases, this may be of particular importance ensure the smooth operation of the printing unit. Preferably the Printing unit is not heated by the IR radiating unit because heat may change the rheology of the printed ink and thus change the printing performance.

The device of the second aspect comprises a UV radiating unit configured to apply UV-radiation to the printed structure or the sintered structure to obtain a conductive structure. The UV radiating unit comprises a UV-source emitting electromagnetic radiation having a wavelength in the range from 100 nm to 450 nm. The power emitted by the UV-source is sufficient to effect the conversion of the molecular metal precursor to metallic metal. This may convert the printed structure and or the sintered structure into a conductive structure. The UV radiating unit has means to adjust the emitted power of UV radiation.

The UV radiating unit may have one or more slots arranged such that more than one electronic substrate, in particular electronic substrates having at least one sintered structure, can be irradiated in parallel. Preferably the UV radiating unit is stationary and the electronic substrates comprising printed structures and or sintered structures are transported to the UV radiating unit.

It is preferred that the UV radiating unit is arranged to irradiate the printed structure or the sintered structure while in parallel the printing unit prints molecular metal precursor ink on a second electronic substrate having an electrically insulating surface.

Optionally the device comprises a cleaning unit. The cleaning unit is e.g. configured to receive electronic substrates from the input stage. In some examples, the cleaning stage comprises a plasma cleaning unit or a wet chemical cleaning unit. The cleaning unit can for example be used to remove particles or molecular contaminants adsorbed to the surface of the electronic substrate. This may improve the adhesion of the conductive structure to the surface of the electronic component, in particular the adhesion to the electrically insulating surface.

In some embodiments the device comprises a flipping unit configured to change the orientation of the electronic substrate such that the printing unit can print molecular metal precursor on a second electrically insulating surface and the IR- and the UV radiating unit can irradiate this second electrically insulating surface. Typically, the substrate is flipped over by 180°, i.e. from top to bottom The features specified for the first electrically insulated surface optionally apply to the second electrically insulating surface. The flipping unit may be arranged such that the electronic substrates can be transported back to the printing stage and the subsequent irradiating stages (IR and UV) or the flipping unit can be arranged such that the electronic substrates after flipping are transported to a second printing unit. The flipping unit flips one or more electronic substrates from one side to the other such that the process of the invention can be carried out on a second electrically insulating surface of the electronic component.

The optional oven of the device is designed to heat one or more electronic substrates, which may or may not comprise electronic structures, to a temperature in the range from 50°C to 250°C. The oven is preferably arranged after the UV radiating unit such that preferably the electronic substrates can be heated after the last UV radiation treatment of a conductive structure, either on the first electrically insulating surface or the second electrically insulating surface is finished. The oven can provide a well-controlled heat treatment with low cost for high quantities of substrates. This is especially useful for mass production of sensitive components, of PCBA or of other semiconductor products by inkjet printing of

The following schematic drawings show aspects of the invention for improving the understanding of the invention in connection with some exemplary illustrations.

### LIST OF REFERENCE NUMERALS

- 5: Transporting means
- 10: Input stage
- 20: Printing unit
- 30: IR radiating unit
- 40: UV radiating unit
- 50: Oven
- 60: Flipping unit
- 100: Providing electronic substrate
- 110: cleaning
- 120, 120': printing
- 130, 130': IR treatment
- 140, 140': UV treatment
- 150,: Heat treatment
- 160: Flipping electronic substrate
- 205: Electronic substrate
- 210: Circuit board
- 220, 220': Printing unit
- 223: Thermal insulation
- 240: Dielectric material
- 245: Molecular metal precursor ink
- 250: Electronic component
- 260: Printed structure

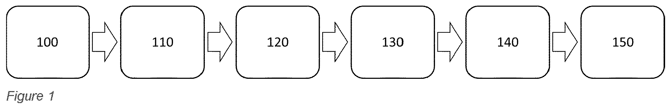

Figure 1 depicts a flow chart of one possible process according to the invention.

After providing a first electronic substrate comprising a first electrically insulating surface (100), the first insulating surface is optionally cleaned in a cleaning step (110). After cleaning (110) follows a printing step (120) of a molecular metal precursor ink on at least a part of the first electrically insulating surface to obtain a printed structure. Following the printing step (120) the printed structures are treated with IR radiation to obtain a sintered structure (130). The sintered structure is treated with UV radiation to obtain a conductive structure (140). Optionally the whole electronic substrate comprising the obtained conductive structure is heated in an oven (150).

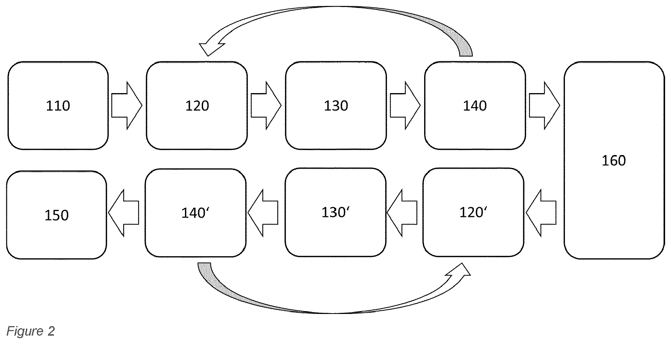

Figure 2 depicts a flow chart of another process according to the invention.

The steps (110 - 140) can be carried out according to Example 1. Optionally steps (120-140) may be repeated once or several times. This may be required if higher layer thicknesses of the conductive structures shall be achieved. After one or more rounds of steps (120)-(140) the electronic substrate may be flipped in a flipping step (160), such that the second electrically insulating surface of the electronic substrate is accessible for a printing step (120').

After flipping the process steps (120', 130' and 140') may be consecutively performed on the second electrically insulating surface of the electronic substrate one or multiple times. After the last UV radiation step (140') the whole electronic substrate is placed into an oven to perform a final heating step (150). In one option (not shown) heating step (150) may additionally be carried out before flipping step (160).

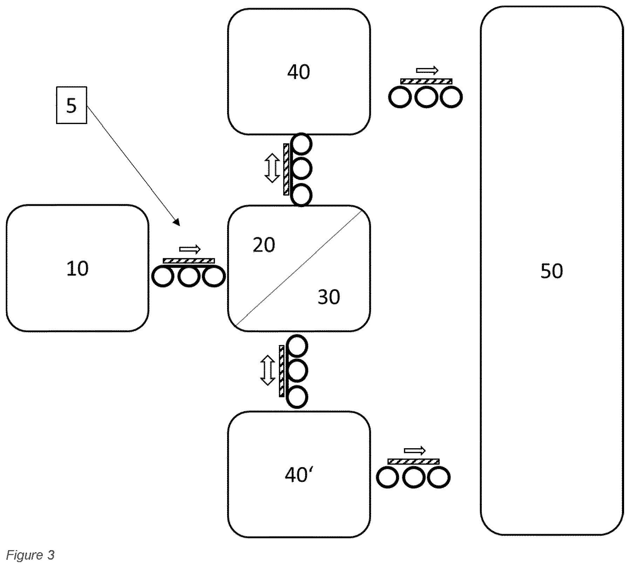

Figure 3 shows a schematic drawing of a device according to the invention.

The electronic substrates are loaded to input stage (10). From input stage (10) the electronic substrate is transported to the printing unit (20) by transporting means (5). In one embodiment the printing unit (20) is provided in the same housing as the IR irradiation unit (30). This is schematically shown by the two reference numbers (20/30) in the same box. Next to the IR radiating unit (30), or in the specific case next to the combined printing and IR radiating unit (20/30), a UV radiating unit (40) is arranged such that the electronic substrate can be transported there for converting the previously sintered structure to a conductive structure. Since the conversion of the sintered structure to a conductive structure takes longer than the printing step the electronic substrate may be treated in the UV radiating unit (40) while a second electronic substrate is fed from the input stage (10) to the printing unit (20) or the combined printing/IR irradiating unit (20/30).

The after the second electronic substrate has been processed in the printing stage (20) and the IR radiating unit (30) it can be transported to a second UV radiating unit (40'). Next to the UV radiating units (40, 40') an optional oven (50) may be arranged. The electronic substrates may be either transported to the oven manually or by transporting means (5).

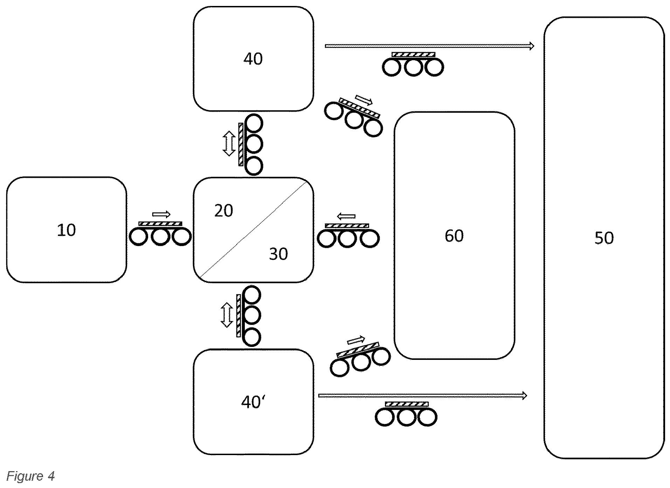

Figure 4 shows another example of a device according to the invention. In addition to the device of Figure 3 a flipping stage (60) has been added. The electronic substrates may be transported to from the UV radiating units (40, 40') to the flipping stage (60). From the flipping stage (60) the electronic substrates may be transported back to the combined printing unit / IR radiating unit (20/30). From the combined printing unit / IR radiating unit (20/30) the electronic substrates may be transported to the UV radiating units (40, 40') and after the final UV treatment the electronic substrates may be transported from the UV radiating units (40, 40') to the oven (50) wherein a final heating step may be performed.

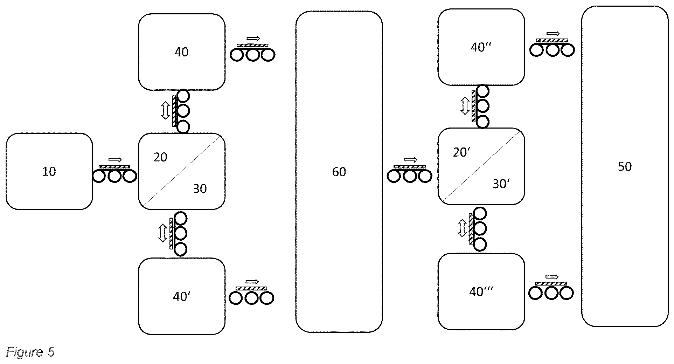

Figure 5 shows another example of a device according to the invention. Instead of the configuration in Figure 4, wherein the flipping stage is arranged to transport the substrates back to the combined printing / IR radiating unit (20/30), here a second printing / IR radiating unit (20'/30') may be arranged receive substrates from the flipping stage (60). In the following the second printing unit / IR radiating unit is connected to further UV radiating units (40", 40‴).

Oven 50 is arranged after further UV radiating units (40", 40‴) to perform a heating step after the last UV treatment of the electronic substrate.

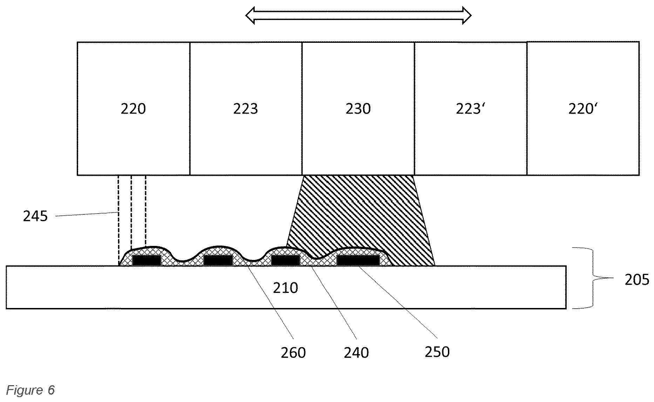

Figure 6 shows an exemplary scheme of a printing unit of the invention, preferably when operated to prepare a sintered structure on a first insulating surface of an electronic substrate (205).

The electronic substrate comprises a circuit board (210) whereon electronic components (250) are arranged. The electronic components are covered with a dielectric material (240) comprising an electrically insulating surface. Preferably the circuit board (210) which is not covered by a dielectric material also comprises an electrically insulating surface. The print head (220) can deposit molecular metal precursor ink (245) on the insulating surface of the dielectric material (240) to form a printed structure (260). The printing unit can move relative to the electronic substrate and preferably the electronic substrate is static while the printing unit moves over the surface of the electronic substrate The printed structure (260) is subsequently radiated with IR radiation emitted by the IR radiating unit (230).

In this particular embodiment the printing unit comprises at least one print head suitable for spraying or jetting molecular metal precursor ink. The printing unit comprises at least one print head (220) which is configured for spraying or jetting molecular metal precursor ink (245). Further the printing unit comprises an IR radiating unit (230) which is preferably configured to emit infrared radiation to sinter the printed structure. The print head (220) and the IR radiating unit (230) are separated from each other by a thermal insulation (223). The thermal insulation (223) shall ensure that the print head (220) is not heated by the IR radiating unit (230). Optionally the printing unit comprises at least a second print head (220') which is preferably also separated from the IR radiating unit (230) by a second thermal insulation (223').

The depicted configuration in Figure 6 comprising at least two print heads (220, 220') on each side of the IR radiating unit (230) has the advantage that the printing unit may operate in two directions such that the printed ink may be directly treated with IR radiation by the IR radiating unit (230). This bi-directional movement is indicated by the two-headed arrow.

While the invention has been described in detail and with reference to specific embodiments thereof, it will be apparent to one skilled in the art that various changes and modifications can be made therein without departing from the spirit and scope thereof. In particular, where applicable features described for the first aspect of the invention are also valid in connection with the second aspect of the invention and vice versa.Thus, it is intended that the invention covers the modifications and variations of this invention provided they come within the scope of the appended claims and their equivalents.

## Claims

1. Process for preparing a conductive structure, in particular an electromagnetic interference shielding, on an electrically insulating surface of a first electronic substrate comprising the steps,
a) providing a first electronic substrate comprising a first electrically insulating surface,
b) printing a molecular metal precursor ink on at least a part of the first electrically insulating surface to obtain a printed structure,
c) treating the printed structure with infrared (IR) radiation to obtain a sintered structure,
d) treating the sintered structure with ultraviolet (UV) radiation to obtain a conductive structure and
e) optionally, after step d) heating the electronic substrate to a temperature of 50°C - 200°C.

2. Process according to claim 1, wherein step c) is carried out in parallel with printing step b).

3. Process according to claim 1 or 2, wherein the electronic substrate has a three-dimensional surface morphology.

4. Process according to anyone of claims 1 - 3, wherein steps b) to d) are repeated once or several times on the electrically insulating surface or on the previously prepared conductive structure or on both.

5. Process according to anyone of claims 1 - 4, wherein step d) is carried out on the first electronic substrate while steps b) and c) are performed on a second electronic substrate.

6. Process according to anyone of claims 1 - 5, wherein in step c) a sintered structure is obtained which comprises not more than 5 wt.-% of a vehicle.

7. Process according to any one of claims 1 - 6), wherein the process steps b) to d) are carried out at least once on a second electrically insulating surface of the first electronic substrate, preferably before step e).

8. Device for manufacturing a conductive structure, in particular an electromagnetic interference shielding on an electronic substrate, comprising
a) an input stage configured to provide at least one first electronic substrate comprising an electrically insulating surface,
b) an ink printing unit configured to print a molecular metal precursor ink on the electrically insulating surface of one or more electronic substrates to form at least a printed structure,
c)an IR radiating unit configured to apply IR radiation to the printed structure to obtain a sintered structure, and
d) a UV radiating unit configured to apply UV radiation to the printed structure or the sintered structure to obtain a conductive structure.

9. Device according to claim 8, wherein the device further includes an oven arranged to heat the electronic substrate after the UV radiating unit.

10. Device according to claim 8 or 9, wherein the IR radiating unit is arranged to irradiate the printed structure while the ink printing unit operates.

11. Device according to any one of claims 8 - 10, wherein the IR radiating unit and the ink printing unit are arranged to move together.

12. Device according to any one of claims 8-11 wherein the UV radiating unit is arranged to irradiate the printed structure or the sintered structure while the printing unit prints on a second electronic substrate.

13. Device according to any one of claims 8 - 12, wherein the device comprises a cleaning unit configured to receive electronic substrates from the input stage wherein the cleaning stage optionally comprises a plasma cleaning unit.

14. Device according to any one of claims 8 - 13, wherein the device comprises a flipping unit configured to change the orientation of the electronic substrate such that the process of any of claims 1 - 7 can be carried out on a second electrically insulating surface of the electronic component.
